# EUROPEAN PATENT APPLICATION

(11) **EP 2 657 309 A1**
(43) Date of publication of application: **30.10.2013**
(21) Application number: 13164701.8
(22) Date of filing: 22.04.2013
(51) Int. Cl.: C09D 183/04, C08L 83/04, H01L 31/00

(54) **Photovoltaic silicone encapsulant and photovoltaic module**

(30) Priority: 23.04.2012 JP 2012097424
(71) Applicant: Shin-Etsu Chemical Co., Ltd., Chiyoda-ku Tokyo (JP)
(72) Inventor: Ohwada, Hiroto, Annaka-shi, Gunma (JP); Furihata, Tomoyoshi, Annaka-shi, Gunma (JP); Kim, Hyung Bae, Annaka-shi, Gunma (JP); Yamakawa, Naoki, Annaka-shi, Gunma (JP); Ito, Atsuo, Annaka-shi, Gunma (JP); Yaginuma, Atsushi, Annaka-shi, Gunma (JP)
(74) Representative: Ter Meer Steinmeister & Partner

(57) **Abstract**

A silicone composition for photovoltaic encapsulation is prepared by blending (A) an organopolysiloxane containing at least two silicon-bonded alkenyl groups per molecule, (B) an organohydrogenpolysiloxane containing at least two silicon-bonded hydrogen atoms per molecule, and (C) an addition reaction catalyst such that the composition when cured may have a water vapor permeability of 80-160 g/m²·day at 40° C and a thickness of 1 mm.

## Description

### TECHNICAL FIELD

This invention relates to a silicone composition for photovoltaic encapsulation, and a photovoltaic module using the composition.

### BACKGROUND ART

Currently, the solar power generation system utilizing the sun's radiation as an energy resource attracts an increasing interest. While the solar cell or photovoltaic element generally comprises a semiconductor, typically silicon, a plurality of such solar cells are electrically interconnected and mounted on a light-receiving side glass plate to construct a photovoltaic module.

For protection from the exterior environment including rain, wind, snow, dust and weather, the solar cell is covered with an encapsulant on its light-receiving surface and back surface. As the encapsulant, ethylene-vinyl acetate copolymers (EVA) are typically used because of low cost.

For example, Patent Document 1 discloses a photovoltaic module using an encapsulant based on an EVA containing 10 to 30% by weight of vinyl acetate. When EVA is used as the encapsulant, however, acetic acid can be generated particularly in a hot humid environment. The generated acid can cause corrosion to solar cell electrodes, detracting from the photovoltaic capability. Since the solar panel is expected to perform over a long period of the order of a few decades, it is urgently desired from an insurance aspect to solve the problem of degradation with time.

Aside from the above problem, EVA has so low UV resistance that it may discolor and turn yellow or brown upon long-term weather exposure, detracting from the outer appearance.

Silicone is one class of encapsulant that has obviated the above-discussed problems. When silicone is used as the encapsulant, the problem of electrode corrosion is substantially inhibited and the yellowing or browning problem is eliminated because no acetic acid is generated. Use of silicone as photovoltaic module encapsulant offers several advantages as pointed out in Non-Patent Document 1, for example.

When the long-term service of photovoltaic modules is examined, an accelerated deterioration test is generally carried out on a photovoltaic module by placing the module in a chamber, providing the chamber with a hot humid environment, and exposing the module to the environment for a certain time so that the module may be acceleratedly degraded. The degradation mechanism is investigated by identifying sites failed in the test. In Patent Document 2, for example, a photovoltaic module using EVA encapsulant is subjected to a pressure cooker test under environmental conditions including temperature 121°C, humidity 100%, and 2 atmospheres for 240 hours. The durability of the photovoltaic module is evaluated in terms of the emission of acetic acid after the test.

For the silicone encapsulant, however, no accelerated deterioration tests have been applied. It is unknown which silicone is appropriate for the photovoltaic module requiring long-term operation.

### Citation List

Patent Document 1: JP-A 2000-183385
Patent Document 2: JP-A 2007-329404
Non-Patent Document 1: Barry Ketola, Keith R. McIntoch, Ann Norris, Mary Kay Tomalia, "Silicone for Photovoltaic Encapsulation": 23rd European Photovoltaic Solar Energy Conference 2008, pp.2969-2973

### DISCLOSURE OF INVENTION

While the invention pertains to a photovoltaic module comprising a photovoltaic cell having front and back surfaces, a front glass plate on the front surface, and a back glass plate on the back surface, wherein solar light is incident on the front surface, an object of the invention is to provide a silicone encapsulant for photovoltaic encapsulation which withstands an outdoor weathering environment over a long term, and a photovoltaic module encapsulated with the composition and having high reliability.

In one aspect, the invention provides a silicone composition for photovoltaic encapsulation comprising
(A) 100 parts by weight of an organopolysiloxane containing at least two silicon-bonded alkenyl groups per molecule, represented by the average compositional formula (1):

   RₐR¹_{b} SiO_{(4-a-b)/2} (1)

   wherein R is alkenyl, R' is a substituted or unsubstituted monovalent hydrocarbon group of 1 to 10 carbon atoms free of aliphatic unsaturation, a and b are numbers in the range: 0 < a ≤ 2, 0 < b < 3, and 0 < a+b ≤ 3,
(B) an organohydrogenpolysiloxane containing at least two silicon-bonded hydrogen atoms per molecule, in such an amount that a molar ratio of silicon-bonded hydrogen in component (B) to silicon-bonded alkenyl in component (A) may be in a range of 0.4/1 to 2.5/1, and
(C) a catalytic amount of an addition reaction catalyst. A cured product of the silicone composition has a water vapor permeability of at least 80 g/m²·day at 40° C and a thickness of 1 mm. Preferably the cured composition has a modulus of elasticity of 0.1 to 5.0 MPa.

In another aspect, the invention provides a photovoltaic module comprising a photovoltaic cell having a front surface on which solar light is incident and a back surface, a front glass plate on the front surface, a backsheet or back glass plate on the back surface, and an encapsulant for encapsulating the cell, the encapsulant being the silicone composition defined above.

### ADVANTAGEOUS EFFECTS OF INVENTION

The silicone composition for photovoltaic encapsulation withstands an outdoor weathering environment over a long term. The photovoltaic module encapsulated with the composition remains highly reliable.

### BRIEF DESCRIPTION OF DRAWINGS

FIG. 1 is a schematic cross-sectional view of a first step in the process of manufacturing a photovoltaic module in one embodiment of the invention.
FIG. 2 is a schematic cross-sectional view of a second step in the process.
FIG. 3 is a schematic cross-sectional view of a third step in the process.
FIG. 4 is a schematic cross-sectional view of a fourth step in the process, showing the finished photovoltaic module.

### DESCRIPTION OF PREFERRED EMBODIMENTS

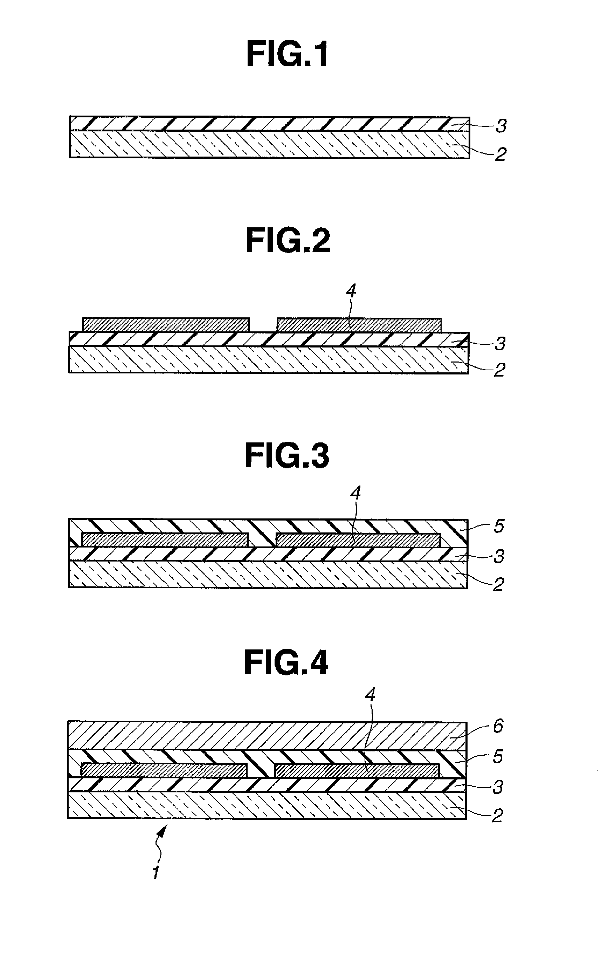

Referring to FIG. 4, a finished photovoltaic module is depicted at 1. The photovoltaic module 1 comprises a photovoltaic cell 4 having a front surface on which solar light is incident and a back surface opposed thereto, a front glass plate 2 disposed on the front surface, and a backsheet or back glass plate 6 disposed on the back surface. The cell 4 is sandwiched or encapsulated between silicone encapsulant layers 3 and 5 of thermosetting silicone resin composition. The invention provides the silicone resin composition of which the encapsulant layers 3 and 5 are made as well as the photovoltaic module 1 comprising the composition.

In one embodiment, the silicone encapsulant for photovoltaic module encapsulation is a thermosetting silicone resin composition comprising components (A) to (C) defined below.

### A) Alkenyl-containing organopolysiloxane

Component (A) is an alkenyl-containing organopolysiloxane serving as a base polymer in the composition. Specifically, it is an organopolysiloxane containing at least two silicon-bonded alkenyl groups per molecule, represented by the average compositional formula (1):

RₐR'_{b}SiO_{(4-a-b)/2} (1)

wherein R is alkenyl, R' is a substituted or unsubstituted monovalent hydrocarbon group of 1 to 10 carbon atoms free of aliphatic unsaturation, a and b are numbers in the range: 0 < a ≤ 2, 0 < b < 3, and 0 < a+b ≤ 3.

The alkenyl-containing organopolysiloxane contains on average at least 2 (specifically 2 to 50), preferably 2 to 20, and more preferably 2 to 10 silicon-bonded alkenyl groups. The alkenyl group represented by R in formula (1) is preferably selected from those of 2 to 10 carbon atoms, more preferably 2 to 8 carbon atoms, such as vinyl, allyl, butenyl, pentenyl, hexenyl and heptenyl, with vinyl being most preferred. The alkenyl group may be bonded at an end and/or side chain of the molecular chain, for example.

The alkenyl-containing organopolysiloxane also contains a silicon-bonded monovalent hydrocarbon group other than alkenyl, specifically a substituted or unsubstituted monovalent hydrocarbon group of 1 to 10 carbon atoms free of aliphatic unsaturation. Examples of the monovalent hydrocarbon group R' include alkyl groups such as methyl, ethyl, propyl, butyl, pentyl, hexyl and heptyl, aryl groups such as phenyl, tolyl, xylyl, and naphthyl, aralkyl groups such as benzyl and phenethyl, and haloalkyl groups such as chloromethyl, 3-chloropropyl and 3,3,3-trifluoropropyl. Inter alia, methyl is preferred in view of UV resistance.

The alkenyl-containing organopolysiloxane may have any molecular structure including linear, partially branched linear, cyclic, branched or three-dimensional network structures, for example. Preferred are a linear diorganopolysiloxane based on a backbone consisting of diorganosiloxane units (D units) and capped with triorganosiloxy at both ends of the molecular chain, and a mixture of a linear diorganopolysiloxane and a branched or three-dimensional network organopolysiloxane.

As used herein, the resinous (branched or three-dimensional network) organopolysiloxane is not particularly limited as long as it contains alkenyl-containing M units and/or D units, and SiO_{4/2} units (Q units) and/or R"SiO_{3/2} (T units) wherein R" is R or R' as defined above. Exemplary are a resinous organopolysiloxane consisting of SiO_{4/2} units (Q units) and M units such as RR'₂SiO_{1/2} units and R'₃SiO_{1/2} units in a molar ratio M/Q of 0.6 to 1.2, and a resinous organopolysiloxane consisting of T units and M units and/or D units.

On use, the linear diorganopolysiloxane and the resinous organopolysiloxane are preferably mixed in a weight ratio of 60:40 to 100:0, more preferably 80:20 to 100:0. A mixture containing more than 40% by weight of the resinous organopolysiloxane may have a high viscosity and be difficult to handle.

In formula (1), a and b are numbers in the range: 0 < a ≤ 2, 0 < b < 3, and 0 < a+b ≤ 3, preferably 0.001 ≤ a ≤ 1, 0.5 ≤ b ≤ 2.5, and 0.5 ≤ a+b ≤ 2.7.

The alkenyl-containing organopolysiloxane as component (A) preferably has a viscosity in the range of 100 to 500,000 mPa·s, more preferably 400 to 100,000 mPa·s when ease of handling and working of the resulting composition and the physical properties of the resulting silicone rubber are taken into account. When the resinous organopolysiloxane is used in combination with the linear diorganopolysiloxane, they are mixed until uniform because the resinous one is dissolvable in the linear one, and the "viscosity" refers to the viscosity of this uniform mixture. Notably, the viscosity is measured by a rotational viscometer.

Examples of the organopolysiloxane as component (A) include, but are not limited to,
trimethylsiloxy-endcapped methylvinylpolysiloxane,
trimethylsiloxy-endcapped dimethylsiloxane/methylvinylsiloxane copolymers,
trimethylsiloxy-endcapped dimethylsiloxane/methylvinylsiloxane/methylphenylsiloxane copolymers,
dimethylvinylsiloxy-endcapped dimethylpolysiloxane,
dimethylvinylsiloxy-endcapped methylvinylpolysiloxane,
dimethylvinylsiloxy-endcapped dimethylsiloxane/methylvinylsiloxane copolymers,
dimethylvinylsiloxy-endcapped dimethylsiloxane/methylvinylsiloxane/methylphenylsiloxane copolymers,
trivinylsiloxy-endcapped dimethylpolysiloxane,
organosiloxane copolymers consisting of siloxane units of the formula: R¹₃SiO_{1/2}, siloxane units of the formula: R¹₂R²SiO_{1/2}, siloxane units of the formula: R¹₂SiO_{2/2}, and siloxane units of the formula: SiO_{4/2}, organosiloxane copolymers consisting of siloxane units of the formula: R¹₃SiO_{1/2}, siloxane units of the formula: R¹₂R²SiO_{1/2}, and siloxane units of the formula: SiO_{4/2}, organosiloxane copolymers consisting of siloxane units of the formula: R¹₂R²SiO_{1/2}, siloxane units of the formula: R¹₂SiO_{2/2}, and siloxane units of the formula: SiO_{4/2}, organosiloxane copolymers consisting of siloxane units of the formula: R¹R²SiO_{2/2} and siloxane units of the formula: R¹SiO_{3/2} or siloxane units of the formula: R²SiO_{3/2}, and a mixture of two or more of the foregoing. It is noted that the term "endcapped" means that a siloxane is capped at both ends of the molecular chain with the referenced groups, unless otherwise stated.

In these formulae, R¹ is a monovalent hydrocarbon group other than alkenyl, examples of which include alkyl groups such as methyl, ethyl, propyl, butyl, pentyl, hexyl and heptyl, aryl groups such as phenyl, tolyl, xylyl, and naphthyl, aralkyl groups such as benzyl and phenethyl, and haloalkyl groups such as chloromethyl, 3-chloropropyl and 3,3,3-trifluoropropyl. R² is an alkenyl group, examples of which include vinyl, allyl, butenyl, pentenyl, hexenyl and heptenyl.

### B) Organohydrogenpolysiloxane

Component (B) is an organohydrogenpolysiloxane containing at least two (specifically 2 to about 300) silicon-bonded hydrogen atoms (i.e., SiH groups) per molecule, preferably at least 3 (specifically 3 to about 150), and more preferably 3 to about 100 SiH groups per molecule. It may have a linear, branched, cyclic or three-dimensional network structure.

Typical organohydrogenpolysiloxane has the average compositional formula (2):

H_{c}R³_{d}SiO_{(4-c-d)/2} (2)

wherein R³ is each independently a substituted or unsubstituted monovalent hydrocarbon group free of aliphatic unsaturation or an alkoxy group, c and d are numbers in the range: 0 < c < 2, 0.8 ≤ d ≤ 2, and 0.8 < c+d ≤ 3, preferably 0.05 ≤ c s 1, 1.5 ≤ d ≤ 2, and 1.8 ≤ c+d ≤ 2.7. The number of silicon atoms per molecule (or degree of polymerization) is preferably 2 to 100, more preferably 3 to 50.

In formula (2), examples of the substituted or unsubstituted, aliphatic unsaturation-free, monovalent hydrocarbon group of R³ are as exemplified for R' in formula (1). Preferably aromatic groups such as phenyl are excluded. Suitable monovalent hydrocarbon groups are those of 1 to 10 carbon atoms, more preferably 1 to 7 carbon atoms, for example, lower alkyl groups of 1 to 3 carbon atoms such as methyl, and haloalkyl groups such as 3,3,3-trifluoropropyl. Suitable alkoxy groups of R³ are those of 1 to 4 carbon atoms such as methoxy and ethoxy. Inter alia, methyl, methoxy and ethoxy are preferred as R³.

Examples of the organohydrogenpolysiloxane include, but are not limited to, siloxane oligomers such as 1,1,3,3-tetramethyldisiloxane,
1,3,5,7-tetramethyltetracyclosiloxane,
1,3,5,7,8-pentamethylpentacyclosiloxane,
methylhydrogencyclopolysiloxane,
methylhydrogensiloxane/dimethylsiloxane cyclic copolymers, tris(dimethylhydrogensiloxy)methylsilane;
trimethylsiloxy-endcapped methylhydrogenpolysiloxane,
trimethylsiloxy-endcapped dimethylsiloxane/methylhydrogensiloxane copolymers,
silanol-endcapped methylhydrogenpolysiloxane,
silanol-endcapped dimethylsiloxane/methylhydrogensiloxane copolymers,
dimethylhydrogensiloxy-endcapped dimethylpolysiloxane,
dimethylhydrogensiloxy-endcapped methylhydrogenpolysiloxane, dimethylhydrogensiloxy-endcapped dimethylsiloxane/methylhydrogensiloxane copolymers,
silicone resins comprising R³₂(H)SiO_{1/2} units and SiO_{4/2} units and optionally R³₃SiO_{1/2} units, R³₂SiO_{2/2} units, R³(H)SiO_{2/2} units, (H)SiO_{3/2} units, or R³SiO_{3/2} units, wherein R³ is as defined above, and modified forms of the foregoing in which some or all methyl groups are substituted by other alkyl groups such as ethyl or propyl. Also included are those of the following formulae. 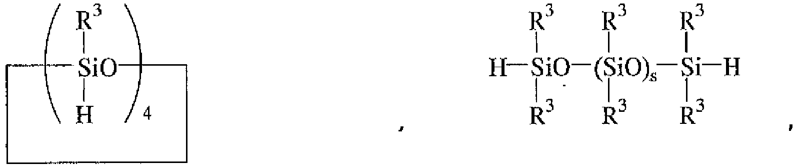 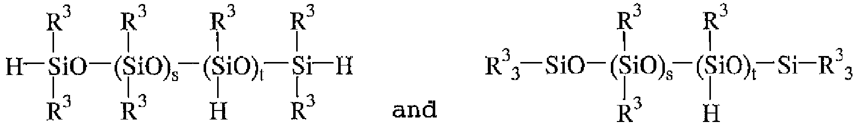 Herein R³ is as defined above, s and t each are 0 or an integer of at least 1.

Any well-known methods may be used to prepare the organohydrogenpolysiloxane. For example, it may be obtained from (co)hydrolysis of at least one chlorosilane selected from those of the formulae: R³SiHCl₂ and R³₂SiHCl wherein R³ is as defined above, or from cohydrolysis of a mixture of the chlorosilane and at least one chlorosilane selected from those of the formulae: R³₃SiCl and R³₂SiCl₂ wherein R³ is as defined above, followed by condensation. Once a polysiloxane is obtained from (co)hydrolysis and condensation, it may be further subjected to equilibration, yielding an organohydrogenpolysiloxane which is also useful.

For further improvement in adhesion, an organohydrogenpolysiloxane containing an epoxy and/or alkoxy group in the molecule is preferably used as at least a portion of component (B). One exemplary epoxy-containing organohydrogenpolysiloxane is shown below.

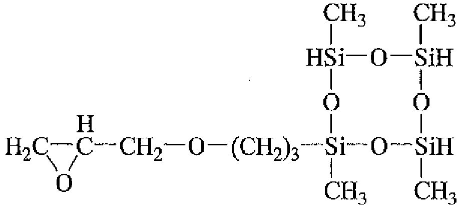

Suitable alkoxysilyl-containing siloxanes are shown below. 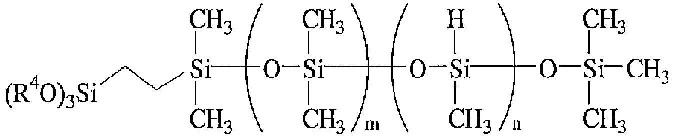 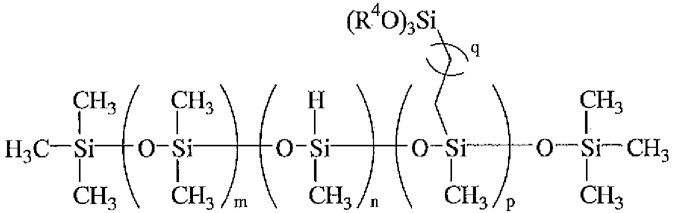 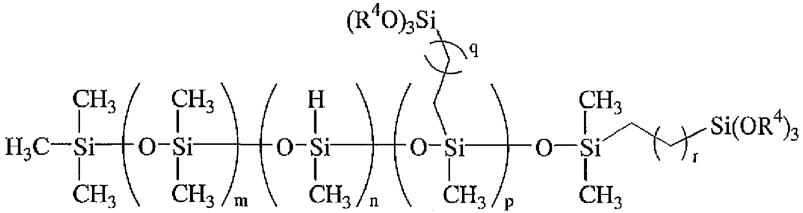 Herein R⁴ is C₁-C₄ alkyl such as methyl or ethyl, m is an integer of at least 0, specifically 0 to 40, n is an integer of at least 2, specifically 2 to 20, p is an integer of at least 1, specifically 1 to 10, and q and r each are an integer of 1 to 3.

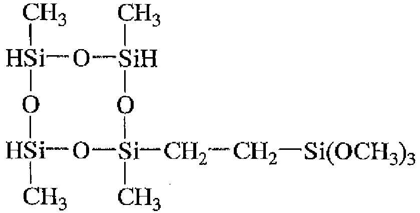

The organohydrogenpolysiloxane as component (B) may be used alone or in admixture of two or more. Component (B) is used in such an amount that a molar ratio of silicon-bonded hydrogen in component (B) to silicon-bonded alkenyl in component (A) may be in a range of 0.4/1 to 2.5/1, preferably 0.7/1 to 1.8/1. Typically, 0.5 to 50 parts by weight, more preferably 1 to 30 parts by weight of component (B) is used per 100 parts by weight of component (A).

### C) Addition reaction catalyst

Component (C) is an addition reaction or hydrosilylation catalyst. It promotes addition reaction of alkenyl groups to silicon-bonded hydrogen atoms (i.e., SiH groups). Many hydrosilylation catalysts, typically platinum group metal-based catalysts are well known in the art.

Of platinum group metal-based catalysts, all those known as the hydrosilylation catalyst may be used. Suitable catalysts include platinum group metals alone such as platinum black, rhodium and palladium; platinum chloride, chloroplatinic acid and salts of chloroplatinic acid such as H₂PtCl₄·yH₂O, H₂PtCl₆·yH₂O, NaHPtCl₆·yH₂O, KHPtCl₆·yH₂O, Na₂PtCl₆·yH₂O, K₂PtCl₄·yH₂O, PtCl₄·yH₂O, PtCl₂, and NaHPtCl₄·yH₂O, wherein y is an integer of 0 to 6, preferably 0 or 6; alcohol-modified chloroplatinic acid as described in USP 3220972; chloroplatinic acid-olefin complexes as described in USP 3159601, USP 3159662, and USP 3775452; platinum black, palladium and other platinum group metals on supports such as alumina, silica and carbon; rhodium-olefin complexes; chlorotris(triphenylphosphine)rhodium, known as Wilkinson catalyst; and complexes of platinum chloride, chloroplatinic acid and chloroplatinate with vinyl-containing siloxanes, typically vinyl-containing cyclic siloxanes. Of these, silicone-modified chloroplatinic acids are preferred from the standpoints of compatibility and chlorine contamination. For example, a platinum catalyst prepared by modifying chloroplatinic acid with tetramethyldivinyldisiloxane is useful.

The platinum group metal-based catalyst is added in a catalytic amount, which typically corresponds to 0.1 to 500 ppm, preferably 0.5 to 100 ppm, and more preferably 1 to 50 ppm of platinum metal based on the total weight of components (A) to (C).

Optionally, a silane coupling agent may be blended in the composition for further improving adhesion. Suitable silane coupling agents include vinyl-containing silane coupling agents such as vinyltrimethoxysilane and vinyltriethoxysilane, epoxy-containing silane coupling agents such as γ-glycidoxypropyltrimethoxysilane and
γ -glycidoxypropyltriethoxysilane, and (meth)acrylic-containing silane coupling agents such as γ-acryloxypropyltrimethoxysilane and
γ -methacryloxypropyltrimethoxysilane. If used, the silane coupling agent is preferably added in an amount of 0.1 to 20 parts, more preferably 0.5 to 10 parts by weight per 100 parts by weight of component (A).

If desired, other well-known additives such as addition reaction inhibitors may be blended insofar as the functions of the essential components are not compromised.

The composition may be prepared by mixing the essential and optional components in a conventional manner. The components to be mixed may be divided into two or more parts wherein those components belonging to each part are mixed together. For example, they are divided into one part consisting of a portion of component (A) and component (C) and another part consisting of the remainder of component (A) and component (B), each part being prepared by mixing the relevant components.

The silicone encapsulant comprising the composition has the propensity that the cured product thereof reduces its water vapor permeability as its crosslinking density increases. Provided that a photovoltaic module is encapsulated with a silicone composition, it has been found that a silicone composition, which cures into a product having a water vapor permeability of at least 80 g/m²·day at 40° C and a thickness of 1 mm, is effective for substantially suppressing a decline with time of the performance of the photovoltaic module. Even though the cured silicone encapsulant allows water vapor to penetrate therethrough, the amount of water vapor remaining at the interface between the encapsulant and the module is minimized so as to cause no fatal degradation to the photovoltaic cell. Since the cured silicone encapsulant itself does not retain moisture, the encapsulant allows excess water vapor to escape away depending on the ambient atmosphere. Preferably the cured product has a water vapor permeability of 80 to 160 g/m²·day, more preferably 80 to 120 g/m²·day at 40°C and a thickness of 1 mm.

In an experiment, the water vapor permeability of cured samples of dimethylsiloxane-structure silicone having different modulus of elasticity was measured at 40°C and a thickness of 1 mm. The water vapor permeability was 155 g/m²·day for the sample having a modulus of elasticity of 0.7 MPa, 110 g/m²·day for 3 MPa, and 40 g/m²·day for 9 MPa. These results indicate a possibility that the water vapor permeability is increased as the modulus of elasticity is reduced. However, if the modulus of elasticity is less than 0.1 MPa, the cured encapsulant may become difficult to maintain its own shape, and the cell can be cracked by any external force accidentally applied from the module back surface or backsheet.

Inversely, if the modulus of elasticity of a cured silicone encapsulant is increased so as to reduce the water vapor permeability, the mechanical strength of the encapsulant is increased. However, the encapsulant with a high modulus of elasticity may undergo expansion and contraction with temperature changes to apply stresses to the tab ribbon on the cell electrode to separate the tab ribbon from the cell electrode, reducing the module's electricity generation efficiency.

A cured silicone encapsulant is given a certain water vapor permeability and modulus of elasticity by changing the number of reactive sites in components (A) and (B). Specifically, those consisting of R¹₃SiO_{1/2}, R¹₂R²SiO_{1/2} and R¹₂SiO_{2/2} units for component (A) and those consisting of R³₃SiO_{1/2}, R³₂SiO_{2/2} and R³(H)SiO_{2/2} units for component (B) bring about a high water vapor permeability and a low modulus of elasticity, whereas incorporation of R¹SiO_{3/2}, SiO_{4/2} and (H)SiO_{3/2} units in components (A) and (B) brings about a low water vapor permeability and a high modulus of elasticity.

When a silicone encapsulant is used in a photovoltaic module, a cured encapsulant having a modulus of elasticity of less than 0.1 MPa is unsuitable because the cured encapsulant cannot retain its own shape. Then a modulus of elasticity of at least 0.1 MPa is essential as a matter of course. As the modulus of elasticity is increased, the water vapor permeability is accordingly reduced. Some encapsulant samples having a high modulus of elasticity are advantageous in an accelerated moisture test, but such samples allow a substantial stress to be applied to the electrode in a thermal cycling test, detracting from the module performance. If the modulus of elasticity exceeds 5.0 MPa, the encapsulant fails to mitigate the stress to the electrode, and cracks may form in the electrode. When the modulus of elasticity is equal to 5.0 MPa, the silicone resin has a water vapor permeability of 80 g/m²·day. Accordingly, the cured encapsulant should preferably have a modulus of elasticity of 0.1 to 5.0 MPa, more preferably 0.1 to 3.0 MPa.

Since the cured product of the thermosetting silicone resin composition is used as a silicone encapsulant in a photovoltaic module, it should preferably have a water vapor permeability of at least 80 g/m²·day and optionally a modulus of elasticity of 0.1 to 5.0 MPa. Then the resulting photovoltaic module withstands an outdoor weathering environment for a long period and remains reliable.

It is desired that the cured silicone encapsulant withstand accelerated degradation tests including a pressure cooker test, thermal cycling test, and condensation freeze test. While the silicone encapsulant is prepared by mixing the components, preferably these test results are fed back in determining the amounts of the components such that the cured product may meet the physical properties in the above-defined ranges.

The pressure cooker test is typically under conditions including temperature 125°C, humidity 100%, and 2 atmospheres and exposure time 100 hours. In the pressure cooker test of a photovoltaic module, no decline of module efficiency is found when the modulus of elasticity is at least 0.1 MPa.

The thermal cycling test typically follows the temperature profile according to IEC61215 standard, specifically a cycle of temperature varying from 85°C to -40°C over 6 hours. In the thermal cycling test of a photovoltaic module over 200 cycles, a cured EVA encapsulant having a high modulus of elasticity will apply a substantial stress to the tab ribbon on the cell electrode to separate the tab ribbon from the cell electrode, resulting in a drop of module's power electricity efficiency.

The condensation freeze test typically follows the temperature/humidity profile according to IEC61215 standard, specifically a cycle of temperature varying from 85°C/85 RH% to -40°C. In the condensation freeze test of a photovoltaic module over 10 cycles, a phenomenon that a substantial stress is applied to the tab ribbon on the cell electrode to separate the tab ribbon from the cell electrode is observed. Also a delamination phenomenon that the cured encapsulant peels off the cell surface is observed. These phenomena result in a drop of module's electricity generation efficiency and have negative impact on the outer appearance.

In the case of cured encapsulants based on EVA or the like having a high modulus of elasticity, detrimental phenomena like separation of tab ribbon from cell electrode often occur. In contrast, no detrimental phenomena are observed for silicone resin encapsulants as long as the cured silicone resin has a water vapor permeability of at least 80 g/m²·day or a modulus of elasticity of 0.1 to 5.0 MPa.

Then, when the thermosetting silicone resin composition in the cured state is used as silicone encapsulant for photovoltaic modules, the cured composition should preferably meet either one of the physical properties, a water vapor permeability of at least 80 g/m²·day and a modulus of elasticity of 0.1 to 5.0 MPa. Then the cured composition exhibits a good balance of properties in any of the accelerated degradation tests.

Another embodiment of the invention is a photovoltaic module using the silicone encapsulant defined above. The photovoltaic module may be fabricated by a process including first to fourth steps as shown in cross-sectional views of FIGS. 1 to 4.

### Photovoltaic module

In the first step, as shown in FIG. 1, a silicone encapsulant or thermosetting silicone resin composition 3 is coated onto a front glass plate 2 (having a solar radiation incident surface) and heat cured at a temperature of 80 to 150°C for a time of 1 to 30 minutes. In the second step, as shown in FIG. 2, individual solar cells 4 are electrically connected into a cell string, which is rested on the silicone encapsulant layer 3. At this point of time, the thermosetting silicone resin composition 3 may be kept partially cured rather than fully cured. Next, in the third step, as shown in FIG. 3, a silicone encapsulant or thermosetting silicone resin composition 5 is coated onto the cell string, so that the cell string is encapsulated in the thermosetting silicone resin compositions 3, 5 or cured layers thereof. Finally, in the fourth step, as shown in FIG. 4, a backsheet or back glass plate 6 (having a back surface opposed to the solar radiation incident surface) is rested thereon, and the coating is heat cured at a temperature of 80 to 150°C for a time of 1 to 30 minutes, yielding a photovoltaic module 1 having solar cells 4 fully encapsulated therein.

The silicone encapsulants or thermosetting silicone resin compositions 3, 5 used in the first and third steps may be a composition which is prepared by adjusting the amounts of components (A) to (C) in the predetermined formulation range such that the finally cured product thereof may meet either one of the desired physical properties, a water vapor permeability of at least 80 g/m²·day and a modulus of elasticity of 0.1 to 5.0 MPa. This can be readily confirmed by previously preparing a small batch of thermosetting composition, curing, and measuring the physical properties thereof. It is noted that the water vapor permeability is measured at 40°C by a water vapor permeation analyzer Lyssy L80-5000, and the modulus of elasticity is measured by a thermomechanical analyzer (TMA) or the like at -40°C to 120°C, typically at 25°C in accordance with the standard procedure (JIS K7129A).

Since it is only required that a cured product having the desired physical properties be finally available, the silicone encapsulants or thermosetting silicone resin compositions 3, 5 used in the first and third steps may be the same or different as long as the amounts of components (A) to (C) are adjusted in the predetermined formulation range.

When the thermosetting silicone resin composition is coated, any well-known coating method may be used such as spray coating, flow coating, curtain coating, screen coating, casting or a combination thereof. It may be coated to a thickness in the range of 10 to 1,000 µm, preferably 50 to 800 µm, and more preferably 100 to 600 µm. A coating of less than 10 µm may fail to accommodate the thickness of solar cells or solar cell strings whereas a coating of more than 1,000 µm suggests an increased cost of curable silicone material.

Once coated, the thermosetting silicone resin composition is heat cured using a well-known heater or furnace such as a hot plate or oven. The heating temperature and time are not necessarily limited to the above-described ranges. If necessary, a post-heating step may be added.

The photovoltaic module is constructed by several components, which are now described. The front glass plate 2 having a solar radiation incident surface may be of float glass, colorless glass, tempered glass or the like. Besides, organic glass is also useful, for example, synthetic resins such as acrylic resin, polycarbonate (PC) resin, polyethylene terephthalate (PET) resin, and epoxy resin.

At the back surface opposed to the solar radiation incident surface, a backsheet like TPT laminate composed of fluoro-resin and PET resin may be used as well as a glass plate like the front glass plate 2. To mitigate a hot spot phenomenon which can locally occur in the photovoltaic module, a metal sheet such as copper, aluminum or iron, or a sheet of a composite material comprising a synthetic resin loaded with a high heat conductivity filler such as silica, titania, alumina or aluminum nitride may also be used.

Also, an outer periphery of the photovoltaic module 1 (FIG. 4) may be covered with a metal frame such as lightweight aluminum alloy or stainless steel to ensure strength against impact, wind pressure or snow and weathering resistance, if necessary. Further, a space defined between the outer periphery of the photovoltaic module 1 and the metal frame may be filled with an edging sealant such as butyl rubber. This seal may be formed by the standard technique.

As used herein, the solar cell may be a cell comprising one or more silicon semiconductor selected from monocrystalline silicon and polycrystalline silicon. A plurality of such solar cells are connected via tab ribbons to form a cell string.

### EXAMPLE

Examples of the invention are given below by way of illustration and not by way of limitation.

### Fabrication of photovoltaic module

As shown in FIG. 1, on a colorless tempered glass plate 2 of 340 mm x 360 mm x 3.2 mm thick, a first thermosetting silicone resin composition 3 was coated to a thickness of 600 µm by flow coating. The plate was held in an oven at 100°C for 10 minutes whereby the coating was cured. Then, as shown in FIG. 2, a cell string of 2 series/2 parallel arranged monocrystalline silicon solar cells 4 was rested on the cured silicone resin 3. Next, as shown in FIG. 3, a second thermosetting silicone resin composition 5 was coated to a thickness of 100 µm by flow coating onto the cell string. As shown in FIG. 4, a colorless tempered glass plate 6 of 340 mm x 360 mm x 3.2 mm thick was rested atop. The assembly was held in an oven at 100°C for 10 minutes whereby the coating was cured, completing a photovoltaic module 1.

### Evaluation of photovoltaic module

The photovoltaic module 1 thus fabricated was measured for initial electricity generation efficiency. It was placed in a pressure cooker tester of 2 atm., 125°C, 100 RH%. After 100 hours of PCT, electricity generation efficiency was measured again, from which a difference before and after the PCT was determined.

The thermal cycling test followed the temperature profile according to IEC61215 standard, specifically a cycle of temperature varying from 85°C to -40°C over 6 hours, the test being repeated 200 cycles. A difference in electricity generation efficiency before and after the thermal cycling test was similarly determined.

The condensation freeze test followed the temperature/humidity profile according to IEC61215 standard, specifically a cycle of temperature varying from 85°C/85 RH% to -40°C, the test being repeated 10 cycles. A difference in electricity generation efficiency before and after the condensation freeze test was similarly determined.

### Examples 1 to 3 & Comparative Examples 1, 2

Five methylsilicone resin compositions were prepared by compounding amounts of components (A) to (C) in the formulation range defined herein such that their cured products had a modulus of elasticity of 0.05, 0.1, 1, 5, and 9 MPa. Photovoltaic modules were fabricated using these compositions as the thermosetting silicone resin compositions 3, 5 and tested as above. The test results are shown in Tables 1 to 3. Notably the cured products had a water vapor permeability of 165, 160, 145, 80, and 40 g/m²·day in the ascending order of modulus of elasticity.

The compositions of Examples 1 to 3 and Comparative Examples 1, 2 are shown below.

### Example 1

To 100 parts by weight of a vinyldimethylsiloxy-endcapped dimethylpolysiloxane having a viscosity of 1,000 mPa·s at 23°C and a vinyl content of 0.012 mol/100 g were added 0.05 part by weight of a dimethylpolysiloxane solution of a chloroplatinic acid/vinylsiloxane complex having a platinum atom content of 1 wt% and 0.01 part by weight of 1-ethynyl-1-hexanol as an addition reaction regulator. The contents were uniformly admixed. To the mixture were added 0.15 part by weight of a methylhydrogenpolysiloxane having Si-H groups at side chains with a Si-H content of 0.0055 mol/g and 8 parts by weight of a methylhydrogenpolysiloxane having Si-H groups at both ends with a Si-H content of 0.001 mol/g. The resulting composition was heat cured at 100°C for 1 hour. The cured product had a modulus of elasticity of 0.1 MPa.

### Example 2

To 100 parts by weight of a vinyldimethylsiloxy-endcapped dimethylpolysiloxane having a viscosity of 1,000 mPa·s at 23°C and a vinyl content of 0.012 mol/100 g were added 25 parts by weight of a resinous copolymer composed of (CH₃)₃SiO_{1/2} units, (CH₂=CH)(CH₃)₂SiO_{1/2} units and SiO₂ units with a molar ratio of [the total of (CH₃)₃SiO_{1/2} units and (CH₂=CH)(CH₃)₂SiO_{1/2} units]/SiO₂ units of 0.8 and a vinyl content of 0.0085 mol/g, 0.06 part by weight of a dimethylpolysiloxane solution of a chloroplatinic acid/vinylsiloxane complex having a platinum atom content of 1 wt% and 0.1 part by weight of 1,3,5,7-tetramethyl-1,3,5,7-tetravinyltetrasiloxane as an addition reaction regulator. The contents were uniformly admixed. To the mixture was added 16 parts by weight of an organohydrogenpolysiloxane shown by the following formula. The resulting composition was heat cured at 100°C for 1 hour. The cured product had a modulus of elasticity of 1 MPa.

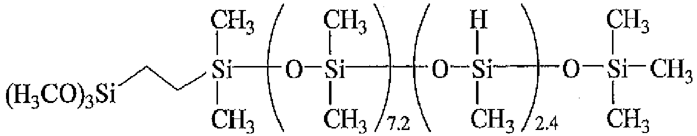

### Example 3

To 100 parts by weight of a vinyldimethylsiloxy-endcapped dimethylpolysiloxane having a viscosity of 5,000 mPa·s at 23°C and a vinyl content of 0.006 mol/100 g were added 100 parts by weight of a resinous copolymer composed of (CH₃)₃SiO_{1/2} units, (CH₂=CH)(CH₃)₂SiO_{1/2} units and SiO₂ units with a molar ratio of [the total of (CH₃)₃SiO_{1/2} units and (CH₂=CH)(CH₃)₂SiO_{1/2} units]/SiO₂ units of 0.8 and a vinyl content of 0.0085 mol/g, 0.2 part by weight of a dimethylpolysiloxane solution of a chloroplatinic acid/vinylsiloxane complex having a platinum atom content of 1 wt% and 0.8 part by weight of 1,3,5,7-tetramethyl-1,3,5,7-tetravinyltetrasiloxane and 0.08 part by weight of 1-ethynyl-1-hexanol as an addition reaction regulator. The contents were uniformly admixed. To the mixture was added 8 parts by weight of an organohydrogenpolysiloxane having Si-H groups at side chains with a Si-H content of 0.015 mol/g and 1.5 parts by weight of an organohydrogenpolysiloxane shown by the following formula. The resulting composition was heat cured at 100° C for 1 hour and then 150° C for 1 hour. The cured product had a modulus of elasticity of 5 MPa.

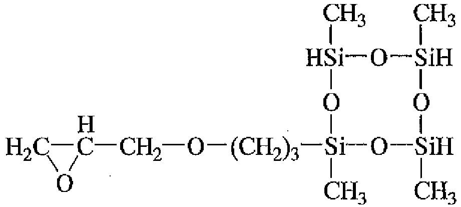

### Comparative Example 1

To 100 parts by weight of a vinyldimethylsiloxy-endcapped dimethylpolysiloxane having a viscosity of 1,000 mPa·s at 23°C and a vinyl content of 0.012 mol/100 g were added 60 parts by weight of a dimethylpolysiloxane capped with a vinyldimethylsiloxy group at one end and having a viscosity of 1,000 mPa·s at 23°C and a vinyl content of 0.0035 mol/100 g, 0.05 part by weight of a dimethylpolysiloxane solution of a chloroplatinic acid/vinylsiloxane complex having a platinum atom content of 1 wt% and 0.005 part by weight of 1,3,5,7-tetramethyl-1,3,5,7-tetravinyltetrasiloxane as an addition reaction regulator. The contents were uniformly admixed. To the mixture were added 0.15 part by weight of a methylhydrogenpolysiloxane having Si-H groups at side chains with a Si-H content of 0.0055 mol/g and 12 parts by weight of a methylhydrogenpolysiloxane having Si-H groups at both ends with a Si-H content of 0.001 mol/g. The resulting composition was heat cured at 100° C for 1 hour. The cured product had a modulus of elasticity of 0.05 MPa.

### Comparative Example 2

To 100 parts by weight of a vinyldimethylsiloxy-endcapped dimethylpolysiloxane having a viscosity of 60 mPa·s at 23°C and a vinyl content of 0.06 mol/100 g were added 300 parts by weight of a resinous copolymer composed of (CH₃)₃SiO_{1/2} units, (CH₂=CH)(CH₃)₂SiO_{1/2} units and SiO₂ units with a molar ratio of [the total of (CH₃)₃SiO_{1/2} units and (CH₂=CH)(CH₃)₂SiO_{1/2} units]/SiO₂ units of 0.8 and a vinyl content of 0.0085 mol/g, 0.6 part by weight of a dimethylpolysiloxane solution of a chloroplatinic acid/vinylsiloxane complex having a platinum atom content of 1 wt% and 12.5 parts by weight of 1,3,5,7-tetramethyl-1,3,5,7-tetravinyltetrasiloxane as an addition reaction regulator and a hardness regulator. The contents were uniformly admixed. To the mixture was added 40 parts by weight of an organohydrogenpolysiloxane having Si-H groups at side chains with a Si-H content of 0.015 mol/g and 20 parts by weight of an organohydrogenpolysiloxane shown by the following formula. The resulting composition was heat cured at 100°C for 1 hour and then 150° C for 1 hour. The cured product had a modulus of elasticity of 9 MPa.

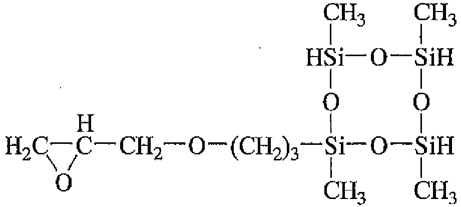

**Table 1**

| PCT (100 hours) | | | |
|---|---|---|---|
| | Modulus of elasticity (MPa) | Water vapor permeability (g/m²·day) | Module efficiency |
| Comparative Example 1 | 0.05 | 165 | shape not retained, unmeasurable |
| Example 1 | 0.1 | 160 | little drop |
| Example 2 | 1 | 145 | little drop |
| Example 3 | 5 | 80 | little drop |
| Comparative Example 2 | 9 | 40 | little drop |

**Table 2**

| Thermal cycling test (200 cycles) | | | |
|---|---|---|---|
| | Modulus of elasticity (MPa) | Water vapor permeability (g/m²·day) | Module efficiency |
| Comparative Example 1 | 0.05 | 165 | shape not retained, unmeasurable |
| Example 1 | 0.1 | 160 | little drop |
| Example 2 | 1 | 145 | little drop |
| Example 3 | 5 | 80 | little drop |
| Comparative Example 2 | 9 | 40 | >10% drop |

**Table 3**

| Condensation freeze test (10 cycles) | | | |
|---|---|---|---|
| | Modulus of elasticity (MPa) | Water vapor permeability (g/m²·day) | Module efficiency |
| Comparative Example 1 | 0.05 | 165 | shape not retained, unmeasurable |
| Example 1 | 0.1 | 160 | little drop |
| Example 2 | 1 | 145 | little drop |
| Example 3 | 5 | 80 | little drop |
| Comparative Example 2 | 9 | 40 | >5% drop |

## Claims

1. In connection with a photovoltaic module comprising a photovoltaic cell having a front surface on which solar light is incident and a back surface, a front glass plate on the front surface, and a backsheet or back glass plate on the back surface,
a silicone composition for encapsulating the photovoltaic cell comprising
(A) 100 parts by weight of an organopolysiloxane containing at least two silicon-bonded alkenyl groups per molecule, represented by the average compositional formula (1):
RₐR'_{b}SiO_{(4-a-b)/2} (1)
wherein R is alkenyl, R' is a substituted or unsubstituted monovalent hydrocarbon group of 1 to 10 carbon atoms free of aliphatic unsaturation, a and b are numbers in the range: 0 < a ≤ 2, 0 < b < 3, and 0 < a+b ≤ 3,
(B) an organohydrogenpolysiloxane containing at least two silicon-bonded hydrogen atoms per molecule, in such an amount that a molar ratio of silicon-bonded hydrogen in component (B) to silicon-bonded alkenyl in component (A) may be in a range of 0.4/1 to 2.5/1, and
(C) a catalytic amount of an addition reaction catalyst,
the silicone composition, when cured, having a water vapor permeability of at least 80 g/m²·day at 40°C and a thickness of 1 mm.

2. The composition of claim 1 wherein the composition, when cured, has a modulus of elasticity of 0.1 to 5.0 MPa.

3. A photovoltaic module comprising a photovoltaic cell having a front surface on which solar light is incident and a back surface, a front glass plate on the front surface, a backsheet or back glass plate on the back surface, and an encapsulant for encapsulating the cell, the encapsulant being the silicone composition of claim 1 or 2.
